# EUROPEAN PATENT APPLICATION

(11) **EP 4 586 320 A1**
(43) Date of publication of application: **16.07.2025**
(21) Application number: 23898170.8
(22) Date of filing: 20.11.2023
(51) Int. Cl.: H01L 27/146

(54) **IMAGE SENSOR AND ELECTRONIC DEVICE COMPRISING SAME**

(30) Priority: 30.11.2022 KR 20220164252; 15.12.2022 KR 20220175957
(71) Applicant: Samsung Electronics Co., Ltd., Suwon-si, Gyeonggi-do 16677 (KR)
(72) Inventor: KIM, Taehwan, Suwon-si, Gyeonggi-do 16677 (KR); JUNG, Hwajoong, Suwon-si, Gyeonggi-do 16677 (KR); KIM, Dongsoo, Suwon-si, Gyeonggi-do 16677 (KR); PARK, Jaehyoung, Suwon-si, Gyeonggi-do 16677 (KR); HEU, Min, Suwon-si, Gyeonggi-do 16677 (KR)
(74) Representative: Appleyard Lees IP LLP
(86) International application number: PCT/KR2023/018692
(87) International publication number: WO 2024/117639

(57) **Abstract**

An image sensor according to one embodiment of the present disclosure may comprise a substrate and a sensor member arranged on one surface of the substrate, wherein the sensor member includes: an active area composed of an arrangement of photoelectric transformation elements; first sensor pads arranged in a first direction at a first side of the circumference of the active area; second sensor pads arranged in the first direction at a second side, opposite to the first side, of the circumference of the active area; and at least one dummy pad arranged at the circumference of the active area. For example, the first sensor pads and the second sensor pads can be electrically connected to the substrate by means of wire bonding. In the one embodiment, the at least one dummy pad is arranged at a third side for connecting one end portion of the first side and one end portion of the second side at the circumference of the active area, and can be electrically connected to any one of the first sensor pads or any one of the second sensor pads by means of wire bonding. Other various embodiments are possible.

## Description

### [Technical Field]

The embodiments of the disclosure relate to an electronic device, for example, an image sensor and/or an electronic device including the same.

### [Background Art]

As electronic, information and communication technologies have developed, various functions have come to be integrated into a single electronic device. For example, a smartphone may include functions of a sound playback device, an imaging device, or a digital diary, in addition to a communication function, and more diverse functions may be implemented in a smartphone through installation of additional applications. An electronic device may be provided with various information in real time by accessing a server or another electronic device in a wired or wireless manner as well as by executing an installed application or a stored file.

As various functions are implemented in single electronic devices (e.g., smartphones), electronic devices such as sound playback devices performing a specific function have already been replaced by smartphones, and the areas of video playback devices or imaging devices are also gradually being replaced by smartphones. In a miniaturized electronic device, since optical performances may be limited, it is possible to enhance the quality of captured images or videos by implementing an imaging function using multiple cameras or multiple image sensors. For example, electronic devices such as smartphones are replacing compact cameras, and it is expected that the electronic devices may replace high-performance cameras such as single-lens reflex cameras in the future.

The above-described information may be provided as background technology for the purpose of aiding in the understanding of the disclosure. No claim or determination is made regarding whether any of the foregoing may be applied as prior art with respect to the disclosure.

### [Detailed Description of the Invention]

### [Technical Solution]

According to an embodiment of the disclosure, an image sensor may include a substrate and a sensor member disposed on one surface of the substrate. In an embodiment, the sensor member may include an active area constituted by an array of photoelectric conversion elements, first sensor pads arranged in a first direction at a first side of the periphery of the active area, second sensor pads arranged in the first direction at a second side of the periphery of the active area opposite to the first side, and at least one dummy pad disposed at the periphery of the active area. For example, the first sensor pads and the second sensor pads may be electrically connected to the substrate by wire bonding. In an embodiment, the at least one dummy pad may be disposed at a third side of the periphery of the active area, which connects one end portion of the first side and one end portion of the second side, and may be electrically connected to one of the first sensor pads or one of the second sensor pads by wire bonding.

According to an embodiment of the disclosure, an electronic device may include a housing including a front surface, a rear surface facing away from the front surface, and a side surface structure surrounding a space between the front surface and the rear surface. In an embodiment, the electronic device may include an image sensor disposed inside the housing and configured to receive incident light transmitted through one of the front surface, the rear surface, and the side surface structure. In an embodiment, the electronic device may include a processor configured to obtain an image of a subject based on the light received through the image sensor. In an embodiment, the image sensor may include a substrate and a sensor member disposed on one surface of the substrate. In an embodiment, the sensor member may include an active area constituted by an array of photoelectric conversion elements, first sensor pads arranged in a first direction at a first side of the periphery of the active area, second sensor pads arranged in the first direction at a second side of the periphery of the active area opposite to the first side, and at least one dummy pad disposed at the periphery of the active area. In an embodiment, the first sensor pads and the second sensor pads may be electrically connected to the substrate by wire bonding. In an embodiment, the at least one dummy pad may be disposed at a third side of the periphery of the active area, which connects one end portion of the first side and one end portion of the second side, and may be electrically connected to one of the first sensor pads or one of the second sensor pads by wire bonding.

### [Brief Description of Drawings]

The above-described aspects or other aspects, configurations, and/or advantages regarding an embodiment of the disclosure may become more apparent through the following detailed description made with reference to the accompanying drawings.
FIG. 1 is a block diagram illustrating an electronic device according to an embodiment of the disclosure within a network environment.
FIG. 2 is a front perspective view of an electronic device according to an embodiment of the disclosure.
FIG. 3 is a rear perspective view of the electronic device according to an embodiment of the disclosure illustrated in FIG. 2.
FIG. 4 is a front exploded perspective view illustrating the electronic device according to an embodiment illustrated in the disclosure of FIG. 2.
FIG. 5 is a rear exploded perspective view illustrating the electronic device according to an embodiment of the disclosure illustrated in FIG. 2.
FIG. 6 is a view illustrating a state in which a camera module is disposed in an electronic device according to an embodiment of the disclosure.
FIG. 7 is a perspective view illustrating an image sensor according to an embodiment of the disclosure.
FIG. 8 is a view illustrating a wire bonding structure of an image sensor according to an embodiment of the disclosure.
FIG. 9 is a view illustrating an electrical connection structure of an image sensor according to an embodiment of the disclosure.
FIG. 10 is a view illustrating an electrical connection structure of an image sensor according to an embodiment of the disclosure.
FIGS. 11 and 12 are views each illustrating an electrical connection structure of an image sensor according to an embodiment of the disclosure.

Throughout the appended drawings, like reference numerals may be assigned to like components, configurations, and/or structures.

### [Mode for Carrying out the Invention]

As the use of miniaturized and portable electronic devices, such as smartphones and tablet PCs, becomes widespread, user demands for the performance of electronic devices may increase. By equipping a single electronic device with multiple cameras and/or image sensors, the optical performance of the electronic device and the quality of acquired images may be improved. However, as electronic devices become more compact, there may be difficulties in mounting multiple image sensors. Although the quality of captured images is improving as image sensors become larger and offer high performance, it may be difficult to secure installation space or stable electrical wiring for high-performance image sensors in miniaturized electronic devices.

An embodiment of the disclosure aims to at least resolve the above-described issues and/or disadvantages and at least provide the advantages described below. The embodiment of the disclosure may provide an image sensor, which achieves enhanced captured image quality while reducing installation space, and/or an electronic device including the image sensor.

An embodiment of the disclosure may provide an image sensor, which allows easy installation in a limited space while becoming larger or offering high performance, and/or an electronic device including the image sensor.

The technical issues to be addressed by the disclosure are not limited to those described above, and other technical issues may be clearly understood by a person ordinarily skilled in the related art to which the disclosure pertains.

The following description with reference to the appended drawings may provide an understanding of various exemplary implementations of the disclosure, including the claims and their equivalents. An exemplary embodiment disclosed in the following description includes various specific details to help understanding, but is considered to be one of various exemplary embodiments. Accordingly, it will be understood by a person ordinarily skilled in the art that various implementations described herein may be variously changed and modified without departing from the scope and spirit of the disclosure. In addition, descriptions of well-known functions and configurations may be omitted for clarity and brevity.

The terms and words used in the following description and claims are not limited to a bibliographical meaning, but may be used to describe an embodiment of the disclosure clearly and consistently. Accordingly, it will be apparent to those skilled in the art that the following description of various implementations of the disclosure is provided for explanatory purposes and not intended to limit the scope of the disclosure and equivalents thereof.

Unless the context clearly indicates otherwise, the singular forms of "a," "an," and "the" should be understood to include the plural meaning. Accordingly, for example, the term "a component surface" may be understood to include one or more surfaces of the component.

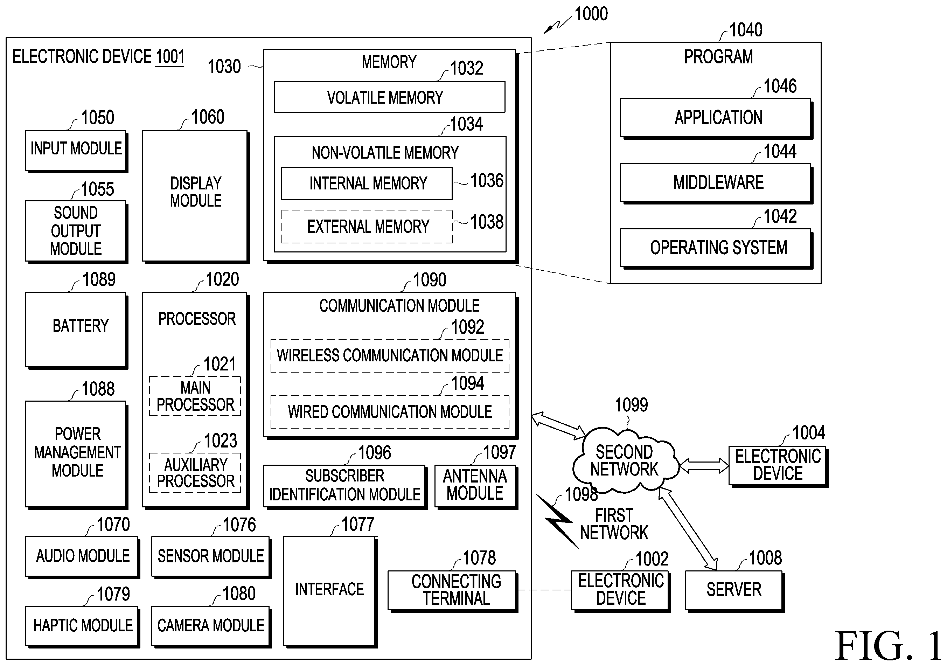

FIG. 1 is a block diagram illustrating an electronic device 1001 in a network environment 1000 according to various embodiments. Referring to FIG. 1, the electronic device 1001 in the network environment 1000 may communicate with an electronic device 1002 via a first network 1098 (e.g., a short-range wireless communication network), or at least one of an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module (SIM) 1096, or an antenna module 1097. In some embodiments, at least one of the components (e.g., the connecting terminal 1078) may be omitted from the electronic device 1001, or one or more other components may be added in the electronic device 1001. In some embodiments, some of the components (e.g., the sensor module 1076, the camera module 1080, or the antenna module 1097) may be implemented as a single component (e.g., the display module 1060).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 1021. For example, when the electronic device 1001 includes the main processor 1021 and the auxiliary processor 1023, the auxiliary processor 1023 may be adapted to consume less power than the main processor 1021, or to be specific to a specified function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 1023. According to an embodiment, the auxiliary processor 1023 (e.g., the neural processing unit) may include a hardware structure specified for artificial intelligence model processing. An artificial intelligence model may be generated by machine learning. Such learning may be performed, e.g., by the electronic device 1001 where the artificial intelligence is performed or via a separate server (e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by another component (e.g., the processor 1020) of the electronic device 1001, from the outside (e.g., a user) of the electronic device 1001. The input module 1050 may include, for example, a microphone, a mouse, a keyboard, a key (e.g., a button), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display module 1060 may include, for example, a display, a hologram device, or a projector and control circuitry to control a corresponding one of the display, hologram device, and projector. According to an embodiment, the display module 1060 may include a touch sensor adapted to detect a touch, or a pressure sensor adapted to measure the intensity of force incurred by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., an electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 1001, and then generate an electrical signal or data value corresponding to the detected state. According to an embodiment, the sensor module 1076 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or a movement) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to one embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via the first network 1098 (e.g., a short-range communication network, such as Bluetooth^{™}, wireless-fidelity (Wi-Fi) direct, or infrared data association (IrDA)) or the second network 1099 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1092 may identify and authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device) of the electronic device 1001. According to an embodiment, the antenna module 1097 may include an antenna including a radiating element composed of a conductive material or a conductive pattern formed in or on a substrate (e.g., a printed circuit board (PCB)). According to an embodiment, the antenna module 1097 may include a plurality of antennas (e.g., array antennas). In such a case, at least one antenna appropriate for a communication scheme used in the communication network, such as the first network 1098 or the second network 1099, may be selected, for example, by the communication module 1090 (e.g., the wireless communication module 1092) from the plurality of antennas. The signal or the power may then be transmitted or received between the communication module 1090 and the external electronic device via the selected at least one antenna. According to an embodiment, another component (e.g., a radio frequency integrated circuit (RFIC)) other than the radiating element may be additionally formed as part of the antenna module 1097.

According to various embodiments, the antenna module 1097 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1001 and the external electronic device 1004 via the server 1008 coupled with the second network 1099. Each of the electronic devices 1002 or 1004 may be a device of a same type as, or a different type, from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In another embodiment, the external electronic device 1004 may include an internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

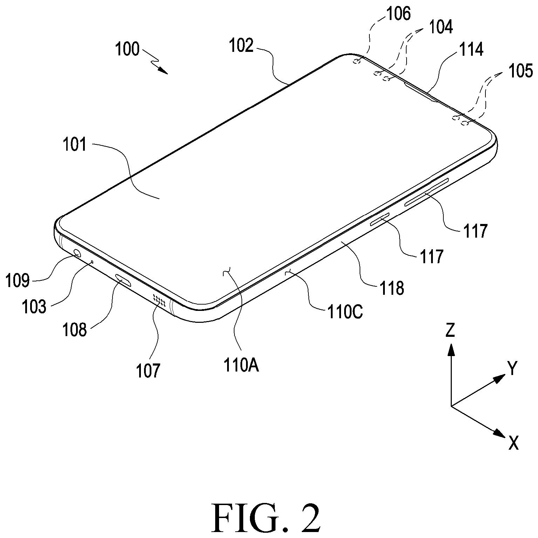

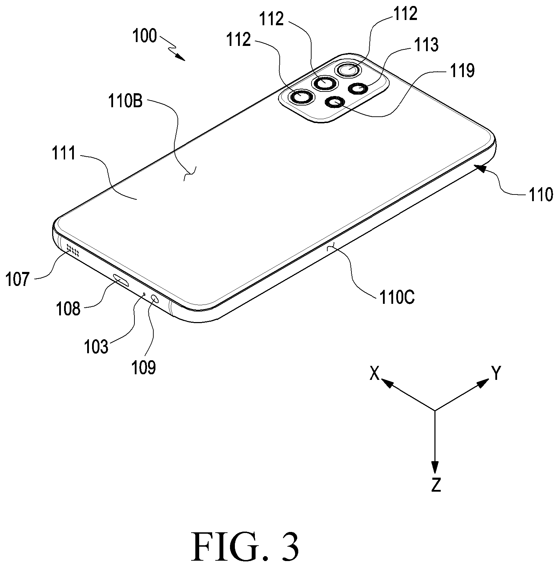

FIG. 2 is a front perspective view of an electronic device 100 according to an embodiment of the disclosure. FIG. 3 is a rear perspective view of the electronic device 100 of FIG. 2 according to an embodiment of the disclosure.

Referring to FIGS. 2 and 3, the electronic device 100 (e.g., the electronic device 1001 in FIG. 1) according to an embodiment may include a housing 110 including a first surface (or the front surface) 110A, a second surface (or the rear surface) 110B, and a side surface 110C surrounding the space between the first surface 110A and the second surface 110B. In an embodiment (not illustrated), the housing 110 may refer to a structure that forms a portion of the first surface 110A of FIG. 2, and the second surface 110B and the side surface 110C of FIG. 3. According to an embodiment, at least a portion of the first surface 110A may be made of a substantially transparent front surface plate 102 (e.g., a glass plate or a polymer plate including various coating layers). The second surface 110B may be made of a substantially opaque rear surface plate 111. The rear surface plate 111 may be made of, for example, coated or colored glass, ceramic, polymer, metal (e.g., aluminum, stainless steel (STS), or magnesium), or a combination of two or more of these materials. The side surface 110C may be defined by the side surface structure (or a "side surface bezel structure") 118 coupled to the front surface plate 102 and the rear surface plate 111 and including metal and/or polymer. In an embodiment, the rear surface plate 111 and the side surface structure 118 may be integrated with each other and may include the same material (e.g., a metal material such as aluminum).

Although not illustrated, the front surface plate 102 may include one or more areas that are curved and extend seamlessly from at least a portion of an edge toward the rear surface plate 111. In an embodiment, the front surface plate 102 (or the rear surface plate 111) may include only one of the areas bent and extending toward the rear surface plate 111 (or the front surface plate 102), at one side edge of the first surface 110A. According to an embodiment, the front surface plate 102 or the rear surface plate 111 may have a substantially flat plate shape, and in this case, may not include a bent and extending area. When the bent and extending area is included, the thickness of the electronic device 100 in the portion including the bent and extending area may be smaller than the thicknesses of other portions.

According to an embodiment, the electronic device 100 may include at least one of a display 101, an audio module (e.g., a microphone hole 103, an external speaker hole 107, and a call receiver hole 114), a sensor module (e.g., a first sensor module 104, a second sensor module (not illustrated), and a third sensor module 119), a camera module (e.g., a first camera device 105, a second camera device 112, and a flash 113), key input devices 117, a light-emitting element 106, and connector holes (e.g., a first connector hole 108 and a second connector hole 109). In an embodiment, in the electronic device 100, at least one of the components (e.g., the key input devices 117 or the light-emitting element 106) may be omitted, or other components may be additionally included.

According to an embodiment, the display 101 may output a screen or may be visually exposed through, for example, a significant portion of the first surface 110A (e.g., the front surface plate 102). In an embodiment, at least a portion of the display 101 may be visually exposed through the front surface plate 102 forming the first surface 110A or through a portion of the side surface 110C. In an embodiment, the edge of the display 101 may be formed to be substantially the same as the shape of the periphery of the front surface plate 102 adjacent thereto. In an embodiment (not illustrated), the distance between the periphery of the display 101 and the periphery of the front surface plate 102 may be substantially constant in order to enlarge the visually exposed area of the display 101.

In an embodiment (not illustrated), recesses or openings may be provided in some portions of the screen display area of the display 101, and one or more of an audio module (e.g., the call receiver hole 114), a sensor module (e.g., the first sensor module 104), a camera module (e.g., the first camera module 105), and a light-emitting element 106 may be aligned with the recesses or the openings. In an embodiment (not illustrated), the rear surface of the screen display area of the display 101 may include at least one of an audio module (e.g., the call receiver hole 114), a sensor module (e.g., the first sensor module 104), a camera module (e.g., the first camera device 105), a fingerprint sensor (not illustrated), and a light-emitting element 106. In an embodiment (not illustrated), the display 101 may be coupled to or disposed adjacent to a touch-sensitive circuit, a pressure sensor capable of measuring a touch intensity (pressure), and/or a digitizer configured to detect an electromagnetic field-type stylus pen. In an embodiment, when the front surface plate 102 or the rear surface plate 111 includes the curved and extended area(s), at least a portion of the sensor modules (e.g., the first sensor module 104 and the third sensor module 119), and/or at least a portion of the key input devices 117 may be arranged in the curved and extended area(s).

According to an embodiment, the audio module 103, 107, and 114 may include a microphone hole 103 and speaker holes (e.g., the external speaker hole 107 and the call receiver hole 114). A microphone configured to acquire external sound may be placed inside the microphone hole 103, and in an embodiment, multiple microphones may be placed to detect the direction of sound. The speaker holes may include an external speaker hole 107 and a call receiver hole 114. In an embodiment, the speaker holes (e.g., the external speaker hole 107 and the call receiver hole 114) and the microphone hole 103 are implemented as a single hole, or a speaker may be included without the speaker holes (e.g., the external speaker hole 107 and the call receiver hole 114) (e.g., a piezo speaker).

According to an embodiment, the sensor modules may generate electrical signals or data values corresponding to an internal operating state or an external environmental state of the electronic device 100. The sensor modules may include, for example, a first sensor module 104 (e.g., a proximity sensor) and/or a second sensor module (not illustrated) (e.g., a fingerprint sensor) disposed on the first surface 110A of the housing 110, and/or a third sensor module 119 disposed on the second surface 110B of the housing 110. The second sensor module (not illustrated) (e.g., a fingerprint sensor) may be disposed not only on the first surface 110A (e.g., the display 101) of the housing 110, but also on the second surface 110B or the side surface 110C of the housing 110. The electronic device 100 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera module may include a first camera device 105 disposed on the first surface 110A of the electronic device 100, and a second camera device 112 and/or a flash 113 disposed on the second surface 110B of the electronic device 100. The camera devices (e.g., the first camera device 105 and the second camera device 112) may include one or more lenses, an image sensor, and/or an image signal processor. The flash 113 may include, for example, a light-emitting diode or a xenon lamp. In an embodiment, one or more lenses (e.g., an infrared camera lens, a wide-angle lens, and a telephoto lens) and image sensors may be disposed on one surface of the electronic device 100. In an embodiment, the flash 113 may emit infrared rays, and the infrared light emitted by the flash 113 and reflected by a subject may be received through the third sensor module 119. The electronic device 100 or the processor (e.g., the processor 1020 in FIG. 1) of the electronic device 100 may detect depth information of the subject based on a time point when the infrared rays are received by the third sensor module 119.

According to an embodiment, the key input device 117 may be disposed on the side surface 110C of the housing 110. In an embodiment, the electronic device 100 may not include some or all of the above-mentioned key input devices 117, and key input devices 117, which are not included, may be implemented in another form, such as soft keys, on the display 101. In an embodiment, the key input devices may include a sensor module disposed on the second surface 110B of the housing 110.

According to an embodiment, the light-emitting element 106 may be disposed on, for example, the first surface 110A of the housing 110. The light-emitting element 106 may provide, for example, the state information of the electronic device 100 in an optical form. In an embodiment, the light-emitting element 106 may provide a light source that is linked to the operation of, for example, a camera module (e.g., the first camera device 105). The light-emitting element 106 may include, for example, an LED, an IR LED, and a xenon lamp.

According to an embodiment, the connector holes (e.g., a first connector hole 108 and a second connector hole 109) may include a first connector hole 108, which is capable of accommodating a connector (e.g., a USB connector) configured to transmit/receive power and/or data to/from an external electronic device (e.g., the electronic device 1002 in FIG. 1), and/or a second connector hole (e.g., an earphone jack) 109, which is capable of accommodating a connector for transmitting/receiving an audio signal to/from an external electronic device.

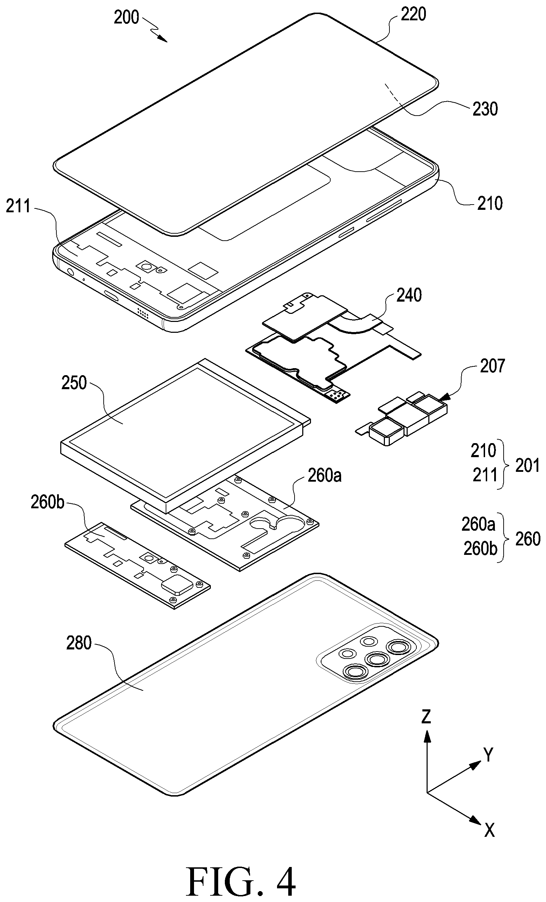

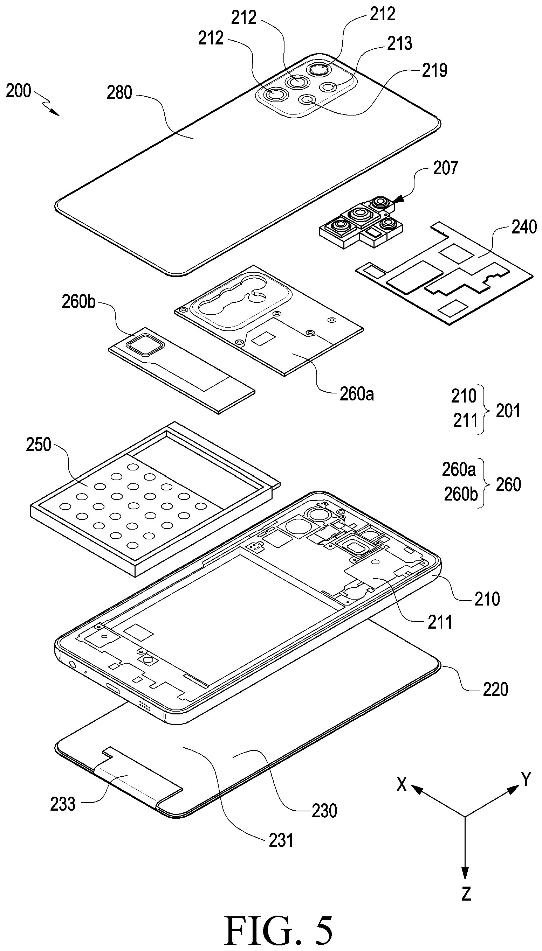

FIG. 4 is a front exploded perspective view illustrating the electronic device 200 according to an embodiment illustrated in the disclosure of FIG. 2. FIG. 5 is a rear exploded perspective view illustrating the electronic device 200 according to an embodiment illustrated in the disclosure of FIG. 2.

Referring to FIGS. 4 and 5, the electronic device 200 (e.g., the electronic device 1001, 1002, 1004, or 100 in FIG. 1, FIG. 2, or FIG. 3) may include a side surface structure 210, a first support member 211 (e.g., a bracket), a front surface plate 220 (e.g., the front surface plate 102 in FIG. 2), a display 230 (e.g., the display 101 in FIG. 2), a printed circuit board (or a substrate assembly) 240, a battery 250, a second support member 260 (e.g., a rear case), an antenna, a camera assembly 207, and a rear surface plate 280 (e.g., the rear surface plate 111 in FIG. 3). In an embodiment, in the electronic device 200, at least one of the components (e.g., the first support member 211 or the second support member 260) may be omitted, or other components may be additionally included. At least one of the components of the electronic device 200 may be the identical or similar to at least one of the components of the electronic device 100 of FIG. 2 or 3, and a redundant description thereof will be omitted below.

According to an embodiment, the first support member 211 may be disposed inside the electronic device 200 to be connected to the side surface structure 210, or may be integrated with the side surface structure 210. The first support member 211 may be made of, for example, a metal material and/or a non-metal (e.g., polymer) material. When at least partially being made of a metal material, a portion of the side surface structure 210 or the first support member 211 may serve as an antenna. The first support member 211 may include one surface to which the display 230 is coupled and the other surface to which the printed circuit board 240 is coupled. A processor (e.g., the processor 1020 in FIG. 1), memory (e.g., the memory 1030 in FIG. 1), and/or an interface (e.g., the interface 1077 in FIG. 1) may be mounted on the printed circuit board 240. The processor may include one or more of, for example, a central processing unit, an application processor, a graphics processing unit, an image signal processor, a sensor hub processor, or a communication processor.

According to an embodiment, the first support member 211 and the side surface structure 210 may be combined to be referred to as a front case or a housing 201. According to an embodiment, the housing 201 may be generally understood as a structure for accommodating, protecting, or disposing the printed circuit board 240 or the battery 250. In an embodiment, it may be understood that the housing 201 includes structures capable of being visually or tactfully recognized by a user in the exterior of the electronic device 200, such as the side surface structure 210, the front surface plate 220, and/or the rear surface plate 280. In an embodiment, the "front surface or rear surface of the housing 201" may be understood as the first surface 110A in FIG. 2 or the second surface 110B in FIG. 3. In an embodiment, the first support member 211 may be disposed between the front surface plate 220 (e.g., the first surface 110A in FIG. 2) and the rear surface plate 280 (e.g., the second surface 110B in FIG. 3) and may serve as a structure on which electrical/electronic components, such as a printed circuit board 240 or a camera assembly 207, are arranged.

According to an embodiment, the display 230 may include a display panel 231 and a flexible printed circuit board 233 extending from the display panel 231. The flexible printed circuit board 233 may be understood, for example, to be electrically connected to the display panel 231 while being disposed at least partially on the rear surface of the display panel 231. In an embodiment, reference number '231' may be understood as denoting a protective sheet disposed on the rear surface of the display panel. For example, unless otherwise classified in the following detailed description, the protective sheet may be understood as being a portion of the display panel 231. In an embodiment, the protective sheet may function as a buffer structure (e.g., a low-density elastic material such as a sponge) absorbing an external force or an electromagnetic shield structure (e.g., a copper sheet (CU sheet)). According to an embodiment, the display 230 may be disposed on the inner surface of the front surface plate 220 and may include a light-emitting layer to output a screen through at least a portion of the first surface 110A of FIG. 2 or the front surface plate 220. As mentioned above, the display 230 may output a screen through substantially the entire area of the first surface 110A of FIG. 2 or the front surface plate 220.

According to an embodiment, the memory may include, for example, volatile memory or nonvolatile memory.

According to an embodiment, the interface may include, for example, a high-definition multimedia interface (HDMI), a universal serial bus (USB) interface, an SD card interface, and/or an audio interface. For example, the interface may electrically or physically connect the electronic device 200 to an external electronic device, and include a USB connector, an SD card/MMC connector, or an audio connector.

According to an embodiment, the second support member 260 may include, for example, an upper support member 260a and a lower support member 260b. In an embodiment, the upper support member 260a may be arranged to surround the printed circuit board 240 together with a portion of the first support member 211. A circuit device implemented in the form of an integrated circuit chip (e.g., a processor, a communication module, or memory) or various electrical/electronic components may be disposed on the printed circuit board 240, and in some embodiments, the printed circuit board 240 may be provided with an electromagnetically shielded environment from the upper support member 260a. In an embodiment, the lower support member 260b may be used as a structure on which electric/electronic components, such as a speaker module and an interface (e.g., a USB connector, an SD card/MMC connector, or an audio connector), are arranged. In an embodiment, electrical/electronic components, such as a speaker module and an interface (e.g., a USB connector, an SD card/MMC connector, or an audio connector), may be disposed on an additional printed circuit board (not illustrated). In this case, the lower support member 260b may be disposed to enclose the additional printed circuit board together with the other portion of the first support member 211. The speaker module or interface disposed on the additional printed circuit board (not illustrated) or the lower support member 260b may be arranged to correspond to the audio module of FIG. 2 (e.g., the microphone hole 103 or the speaker holes (e.g., the external speaker hole 107 and the call receiver hole 114)) or the connector holes (e.g., the first connector hole 108 and the second connector hole 109).

According to an embodiment, the battery 250 is a device that supplies power to at least one component of the electronic device 200, and may include, for example, a non-rechargeable primary battery, a rechargeable secondary battery, or a fuel cell. At least a portion of the battery 250 may be disposed on substantially the same plane as, for example, the printed circuit board 240. The battery 250 may be integrally disposed inside the electronic device 200, or may be disposed to be detachable from the electronic device 200.

Although not illustrated, the antenna may include a conductor pattern implemented on the surface of the second support member 260 through, for example, a laser direct structuring (LDS) method. In an embodiment, the antenna may include a printed circuit pattern provided on the surface of a thin film, and the thin film-type antenna may be disposed between the rear surface plate 280 and the battery 250. The antenna may include, for example, a near-field communication (NFC) antenna, a wireless charging antenna, and/or a magnetic secure transmission (MST) antenna. The antenna may, for example, perform short-distance communication with an external device, or wirelessly transmit and receive power required for charging. In an embodiment, an antenna structure may be configured with a portion or a combination of the side surface structure 210 and/or the first support member 211.

According to an embodiment, the camera assembly 207 may include at least one camera module. Inside the electronic device 200, the camera assembly 207 may receive at least some of light incident through optical holes or camera windows 212, 213, and 219. In an embodiment, the camera assembly 207 may be disposed on the first support member 211 at a position adjacent to the printed circuit board 240. In an embodiment, the camera modules of the camera assembly 207 may be generally aligned with one of the camera windows 212, 213, and 219, and may be at least partially surrounded by the second support member 260 (e.g., the upper support member 260a).

In FIGS. 2 to 5, which illustrate the above-described electronic device 200, the X-axis, the Y-axis, and the Z-axis are illustrated for the sake of conciseness in explaining one or more directions referenced in the embodiments described below. For example, the orthogonal coordinate system in the embodiment of FIG. 2 to FIG. 5 and/or the embodiments described below are provided for ease of explanation. Depending on the structure and specifications of an actually manufactured electronic device or a user's usage habits, the orthogonal coordinate system may be defined differently from what is illustrated in the drawings.

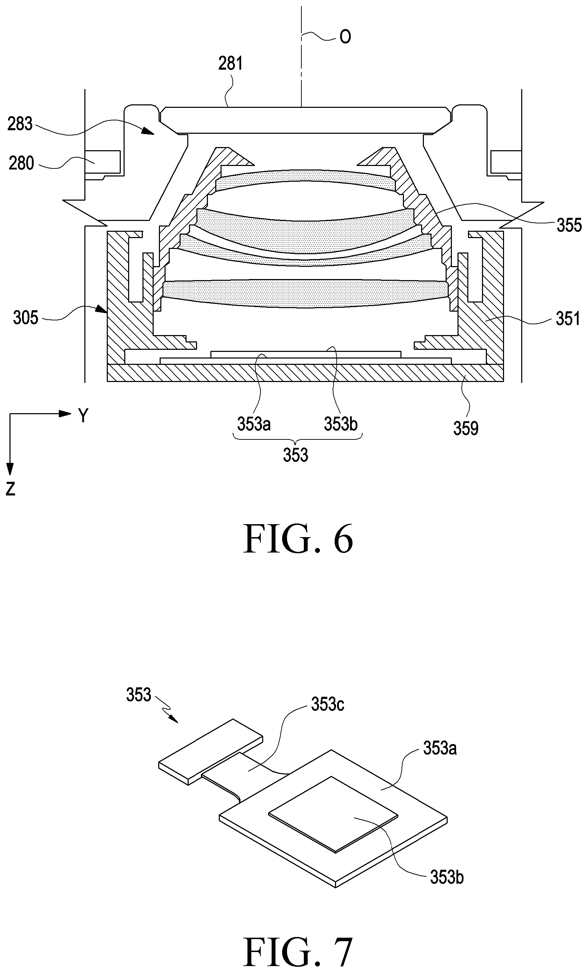

FIG. 6 is a view illustrating a state in which a camera module 305 is disposed in an electronic device (e.g., the electronic device 1001, 1002, 1004, 100, or 200 of FIGS. 1 to 5) according to an embodiment of the disclosure.

Referring to FIG. 6, the camera module 305 may include a lens assembly 355 and an image sensor 353 (e.g., a substrate 353a and a sensor member 353b). In an embodiment, the camera module 305 may be, for example, one of the cameras included in the camera assembly 207 of FIG. 4 or FIG. 5. As will be described later, the image sensor 353 may further include a flexible printed circuit board (e.g., the flexible printed circuit board 353c of FIG. 7) provided with a connector, thereby being electrically connected to a main circuit board (e.g., the printed circuit board 240 of FIG. 4 or FIG. 5) or a processor (e.g., the processor 1020 of FIG. 1). According to an embodiment, an electronic device (e.g., the electronic device 100 or 200 of FIGS. 2 to 5) may include a decoration member 283 disposed to penetrate through a rear surface plate 280. In an embodiment, the decoration member 283 may provide a path through which external light is incident (hereinafter, "photographing path"). For example, a portion of the decoration member 283 may be disposed on or coupled to an inner surface of the rear surface plate 280, while another portion may penetrate through the rear surface plate 280, defining a photographing path. In an embodiment, the photographing path may have a hole shape that substantially penetrates the decoration member 283, and the electronic device 200 may include a window 281 that transmits light, thereby closing the hole of the decoration member 283.

According to an embodiment, the camera module 305 and/or the lens assembly 355 may include at least one lens aligned along an optical axis O and may be disposed inside a housing (e.g., the housing 110 or 201 of FIGS. 2 to 5) while facing the window 281. The electronic device 200 and/or the processor 1020 may perform autofocus adjustment by causing the lens assembly 355 (or lens(es) of the lens assembly 355) to move forward and backward along the optical axis O (e.g., in the Z-axis direction). For example, a space may be provided on the inner side of the window 281 and/or the decoration member 283 to allow the lens assembly 355 to move forward and backward. In an embodiment, the space for forward and backward movement for autofocus adjustment may be understood as a space in which the lens(es) move forward and backward inside the lens assembly 355. In an embodiment, in a plane substantially perpendicular to the optical axis O, the lens assembly 355 may move horizontally with respect to the image sensor 353. For example, when the electronic device 200 and/or the camera module 305 vibrates due to an external force, the lens assembly 355 may move horizontally with respect to the image sensor 353, thereby suppressing the degradation of captured image quality due to the vibration.

According to an embodiment, the electronic device 200 and/or the camera module 305 may further include a casing 351, and the casing 351 may connect or couple the lens assembly 355 and the image sensor 353. In an embodiment, the image sensor 353 may be disposed or fixed on the casing 351 substantially through a bracket 359. For example, the image sensor 353 may be substantially aligned with the lens assembly 355 inside the casing 351 through the bracket 359.

In the following detailed description, for components identical to or easily understood from the above-described embodiments, the same reference numerals may be assigned as in the above-described embodiments, or the reference numerals may be omitted, and a detailed description thereof may be omitted.

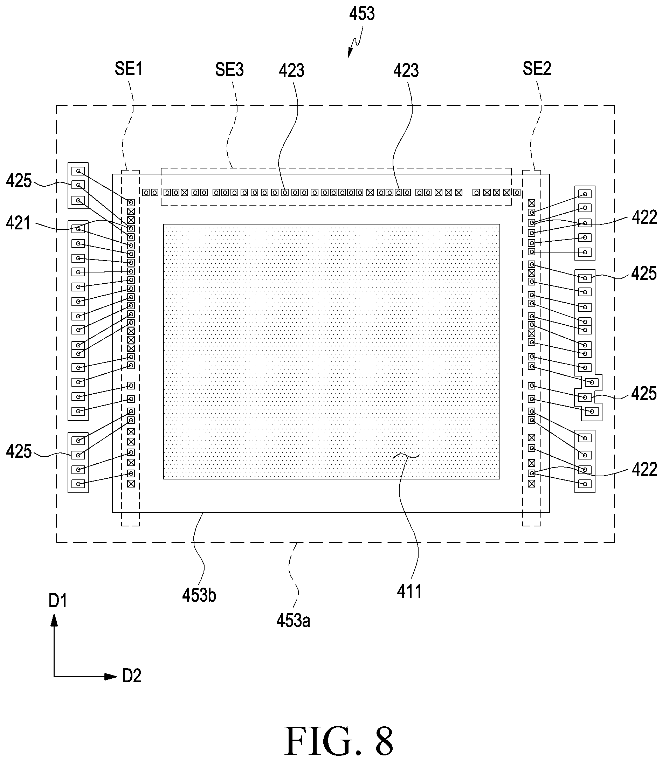

FIG. 7 is a perspective view illustrating an image sensor 353 according to an embodiment of the disclosure. FIG. 8 is a view illustrating a wire bonding structure of an image sensor 453 (e.g., the image sensor 353 of FIG. 7) according to an embodiment of the disclosure.

Further referring to FIGS. 7 and 8, the image sensor 353 or 453 may include a substrate 353a or 453a and a sensor member 353b or 453b. In an embodiment, the sensor member 353b or 453b may include an active area 411 and multiple electrode pads 421, 422, and 423. The active area 411 may be constituted by an array of photoelectric conversion elements, and at least some of the electrical wires embedded in the sensor member 353b or 453b may electrically connect the photoelectric conversion elements to one of the electrode pads 421, 422, and 423. The electrode pads 421, 422, and 423 may be arranged at the periphery of the active area 411. For example, the electrode pads 421, 422, and 423 may be disposed in an inactive area and may be substantially exposed to the outside of the sensor member 353b or 453b. In an embodiment, at least some of the electrode pads 421, 422, and 423 may electrically connect the sensor member 353b or 453b to the substrate 353a or 453a. For example, the electrode pads 421, 422, and 423 may be electrically connected to the substrate 353a or 453a via a wire bonding or ball grid array (BGA) structure. In an embodiment, the image sensor 353 or 453 may receive incident light transmitted through the front surface (e.g., the first surface 110A of FIG. 2), the rear surface (e.g., the second surface 110B of FIG. 3), and/or the side surface structure 210 of FIG. 4 of the electronic device 200. For example, the electronic device 200 and/or the processor 1020 of FIG. 1 may obtain a subject image based on the light received through the image sensor 353 or 453.

In the following description of the embodiments of the disclosure, the electrode pads 421, 422, and 423 may be separately referred to as "sensor pad(s) 421 and 422" or "dummy pad(s) 423." The term "electrode pad(s) 421, 422, and 423" or simply "pad(s)" may be understood to include both the "sensor pad(s) 421 and 422 and the dummy pad(s) 423. In an embodiment, the sensor pad(s) 421, 422 may refer to pads disposed on the sensor member 353b or 453b and electrically connected to the substrate 353a or 453a (or the substrate pad 425 of FIG. 8) via wire bonding. The dummy pad(s) 423 may refer to pads disposed on the sensor member 353b or 453b and electrically connected to one of the sensor pads 421 and 422 by wire bonding. It should be noted that such classifications of terms or components are for the sake of brevity in explanation and do not limit the embodiments of the disclosure. For example, even if a pad is referred to as a "dummy pad," it may still be electrically connected to the substrate pad 425 of FIG. 8 by wire bonding. In an embodiment, a wire electrically connecting the electrode pads 421, 422, and 423 to the substrate pad 425 may include, for example, a conductive material such as silver, aluminum, and/or copper.

According to an embodiment, the image sensor 353 or 453 and/or the electrode pads 421, 422, and 423 may include first sensor pads 421, second sensor pads 422, and at least one dummy pad 423. The first sensor pads 421 may be arranged, for example, in a first direction D1 at a first side SE1 of the periphery of the active area 411. Here, the term "first side SE1 of the periphery of the active area 411" may refer to a portion of an area on one surface of the sensor member 353b or 453b where no photoelectric conversion elements are disposed, and, in the state illustrated in FIG. 8, may correspond to the left side of the active area 411. The first direction D1 may be substantially parallel to the Y-axis direction of FIGS. 2 to 5. However, the embodiments of the disclosure are not limited thereto, and the first direction D1 and the directions illustrated in the orthogonal coordinate system may be variously combined or aligned depending on the structure or specifications of the electronic device 200. The second sensor pads 422 may be arranged, for example, in a first direction D1, at a second side SE2 of the periphery of the active area 411. The term "second side SE2 of the periphery of the active area 411" may refer to another portion of the area on one surface of the sensor member 353b or 453b where no photoelectric conversion elements are disposed, specifically a position or area opposite to the first side SE1 (e.g., the right side of the active area 411).

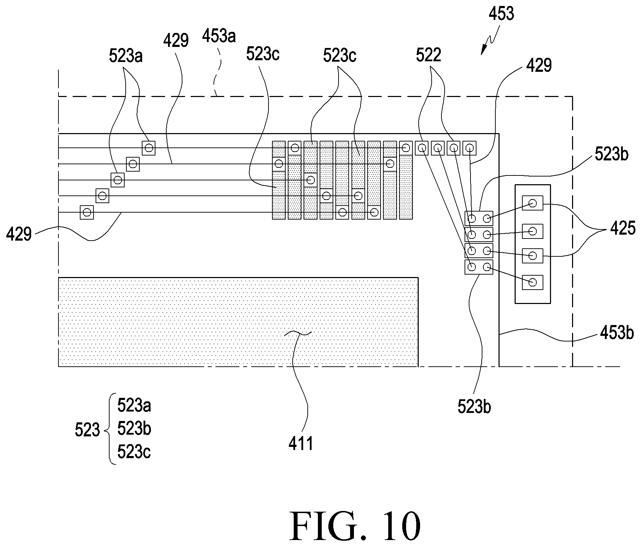

According to an embodiment, the at least one dummy pad 423 may be disposed at the periphery of the active area 411 and may be electrically connected to one of the first sensor pads 421 or one of the second sensor pads 422 by wire bonding. However, the embodiments of the disclosure are not limited thereto, and in a structure where multiple dummy pads 423 are provided, one of the dummy pads 423 (e.g., the dummy pad indicated as "523b" in FIG. 10) may be electrically connected to the substrate pad 425 by wire bonding. In an embodiment, multiple dummy pads 423 may be disposed at the periphery of the active area 411. In an embodiment, the sensor member 353b or 453b may include, at the periphery of the active area 411, a third side SE3 connecting one end portion of the first side SE1 and one end portion of the second side SE2. At least one dummy pad 423 may be disposed, for example, at the third side SE3. Although no reference numeral is assigned, the sensor member 353b or 453b may further include, at the periphery of the active area 411, a fourth side connecting the other end portion of the first side SE1 and the other end portion of the second side SE2. In an embodiment, no sensor pads 421 or 422 and/or dummy pads 423 may be disposed at the fourth side.

According to an embodiment, multiple dummy pads 423 may be arranged in a second direction D2 at the third side SE3. The term "second direction D2" may refer to, for example, a direction crossing the first direction D1 or a direction substantially perpendicular to the first direction D1. In an embodiment, when the first direction D1 is disposed substantially parallel to the Y-axis direction of FIGS. 2 to 5, the second direction D2 may be disposed substantially parallel to the X-axis direction of FIGS. 2 to 5. In an embodiment, although not illustrated, in addition to the dummy pad(s) 423 exemplified in FIG. 8, additional dummy pad(s) may be disposed adjacent to the sensor pad(s) 421 or 422 at the first side SE1 and/or the second side SE2. For example, the arrangement or layout of the dummy pad(s) 423 is not limited to the illustrated embodiments, and the dummy pad(s) 423 may be disposed at any position at the periphery of the active area 411. In a structure where multiple dummy pads 423 are disposed, one of the dummy pads 423 may be electrically connected to another dummy pad(s) by wire bonding. For example, one first sensor pad 421 or one second sensor pad 422 may be electrically connected to two or more of the multiple dummy pads 423.

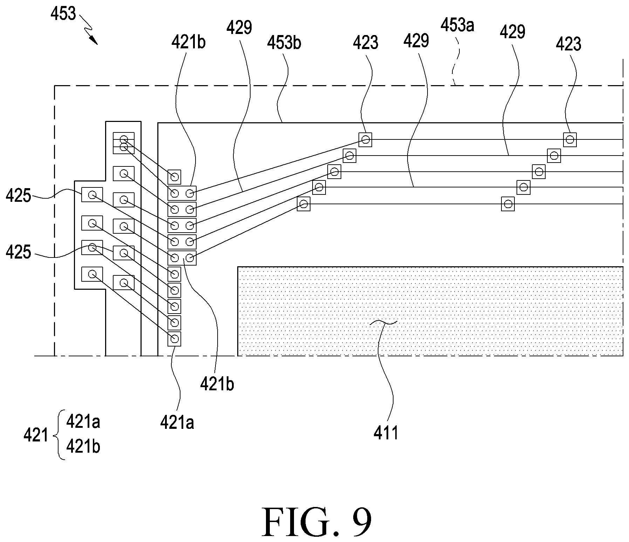

According to an embodiment, at least one wire (hereinafter, the "dummy wire 429" (see FIG. 9 or FIG. 10)) that electrically connects at least one dummy pad 423 to one of the first sensor pads 421 or one of the second sensor pads 422 may function as a wire that electrically connects the photoelectric conversion element(s) of the active area 411 to the substrate 353a or 453a. For example, the at least one dummy pad 423 and/or the dummy wire 429 may supply power or transmit an electrical signal (e.g., an image data signal) between the active area 411 (e.g., photoelectric conversion element(s)) and one of the sensor pads 421 and 422. Accordingly, in addition to the wires implemented inside the sensor member 353b or 453b, additional electrical wires may be provided outside the sensor member 353b or 453b, extending from the sensor pad(s) 421 or 422 to the photoelectric conversion element(s). For example, the additional electrical wires (e.g., at least a portion of the dummy pad(s) 423 and/or dummy wire(s) 429) may be utilized for power supply or electrical signal transmission.

According to an embodiment, by adding electrical wires, the power efficiency of the sensor member 353b or 453b or the stability of data signal transmission may be improved. For example, as additional electrical wires are provided outside the sensor member 353b or 453b, the number of electrical wires inside the sensor member 353b or 453b may be reduced, and the cross-sectional area of the electrical wires may be expanded. As the cross-sectional area of the electrical wires increases, line resistance may be reduced, and the power efficiency of the sensor member 353b or 453b may be improved. In an embodiment, when additional electrical wires are provided outside the sensor member 353b or 453b while maintaining the number of electrical wires inside the sensor member 353b or 453b without reduction, the data signal transmission path may be expanded, and the speed or stability of data signal transmission may be improved. As such, by implementing additional electrical wires using the at least one dummy pad 422 and the dummy wire 429 in the inactive area (e.g., the periphery of the active area 411), the image sensor 353 or 453 may have improved power efficiency and/or data signal transmission efficiency.

According to an embodiment, the image sensor 353 or 453 may further include substrate pads 425 disposed on the substrate 353a or 453a. The substrate pads 425 may be disposed on one surface of the substrate 353a or 453a, on one side or another side of the sensor member 353b or 453b, and may be arranged in the first direction D1. For example, some of the substrate pads 425 may be disposed on the substrate 353a or 453a at positions adjacent to the first side SE1 of the sensor member 353b or 453b, while others of the substrate pads 425 may be disposed on the substrate 353a or 453a at positions adjacent to the second side SE2 of the sensor member 353b or 453b. In an embodiment, wire bonding that electrically connects the sensor member 353b or 453b to the substrate 353a or 453a may be provided substantially between the substrate pads 425 and the sensor pads 421 and 422. For example, the sensor pads 421 and 422 may be electrically connected to one of the substrate pads 425 by wire bonding.

According to an embodiment, although not illustrated, in implementing electrical wires extending from the substrate 353a or 453a to the photoelectric conversion element(s), the image sensor 353 or 453 may further include additional substrate pads (hereinafter, "second substrate pads") disposed on the substrate 353a or 453a at positions adjacent to the third side SE3 of the sensor member 353b or 453b. For example, one of the dummy pads 423 may be electrically connected to one of the second substrate pads disposed adjacent to the third side SE3 of the sensor member 353b or 453b. The dummy pad(s) 423 electrically connected to the second substrate pad may be understood as "third sensor pad(s)." When the second substrate pad and/or the third sensor pad is provided, the image sensor 353 or 453 may have a larger size than that exemplified in FIG. 8. For example, since an area for disposing the second substrate pad and a spacing for implementing wire bonding between the second substrate pad and the third sensor pad should be secured, there may be difficulties in miniaturizing the image sensor 353 or 453. The image sensor 353 or 453 according to embodiments of the disclosure may be miniaturized by omitting wire bonding between the dummy pad at the third side SE3 and the substrate 353a or 453a, thereby reducing the area occupied by the second substrate pad. In an embodiment, by omitting the second substrate pad and achieving miniaturization, the image sensor 353 or 453 may be easily disposed in a confined space.

According to an embodiment, when the image sensor 353 or 453 and/or the sensor member 353b or 453b is disposed inside the electronic device 200, the third side SE3 of the periphery of the active area 411 may be disposed adjacent to an edge of the electronic device 200 (e.g., the side surface structure 210 of FIG. 4 or FIG. 5). In an embodiment, when disposed as the first camera device 105 of FIG. 2, the image sensor 353 or 453 and/or the sensor member 353b or 453b may at least partially overlap the display 101 or 230. For example, the image sensor 353 or 453 and/or the sensor member 353b or 453b may receive external light by passing through a portion of the display 101 or 230 or may be aligned with a recess or an opening provided in a portion of the display 101 or 230.

According to an embodiment, when the second substrate pad is omitted and the third side SE3 of the periphery of the active area 411 is disposed adjacent to an edge of the electronic device 200 (e.g., the upper end located in the + Y direction of FIG. 2), it may be easier to suppress or improve the overlap of the image sensor 353 or 453 and/or the sensor member 353b or 453b with the display 101 or 230. For example, even if the image sensor 353 or 453 and the display 101 or 230 are partially overlapped, the image sensor 353 or 453 and/or the display 101 or 230 may be provided with a stable operating environment. As such, by omitting the substrate pads (e.g., a second substrate pad(s)) disposed adjacent to the third side SE3 of the periphery of the active area 411, the image sensor 353 or 453 may be miniaturized and easily disposed in a confined space. Even if the image sensor is disposed to partially overlap the display 101 or 230, a high-quality image may still be captured or acquired.

FIG. 9 is a view illustrating an electrical connection structure of an image sensor (e.g., the image sensor 353 or 453 of FIG. 7 or FIG. 8) according to an embodiment of the disclosure. FIG. 10 is a view illustrating an electrical connection structure of an image sensor 453 according to an embodiment of the disclosure.

FIGS. 9 and 10 illustrate examples of implementations of wire bonding or electrical wiring disposed on the image sensor 453. In FIGS. 9 and 10, some of the electrode pads 421, 423, 522, and 523 (e.g., the pads indicated by reference numerals "421b," "523b," and "523c") may have a greater length or width than other electrode pads. For example, among the first sensor pads 421 in FIG. 9, the first sensor pad indicated by "421b" may have a greater width or length than another first sensor pad 421a or the dummy pad 423. An electrode pad having a greater width or length another electrode pad may be electrically connected to multiple other pads by wire bonding. For example, an electrode pad having a greater width or length than another electrode pad may be electrically connected to one of the substrate pads 425 via wire bonding and may also be electrically connected to one of the dummy pads 423 by wire bonding. Hereinafter, an electrode pad having a substantially square shape on the sensor member 453b may be referred to as a "normal pad", and an electrode pad having a greater width or length than a normal pad may be referred to as an "enlarged pad." A normal pad may, for example, be electrically connected to another pad by wire bonding and may be connected to yet another pad (or the active area 411) via an electrical wire provided inside the sensor member 453b.

Referring to FIG. 9, the sensor pads (e.g., the first sensor pads 421) may be electrically connected to one of the substrate pads 425 by wire bonding. As illustrated in FIG. 9, the substrate pads 425 may be arranged in two rows in one direction (e.g., the first direction D1 of FIG. 8). For example, when arranging the substrate pads 425 and electrical wires (e.g., a printed circuit pattern) on the substrate 453a, it should be noted that their positions and arrangements are not limited to the embodiments illustrated in the drawings. The normal pads 421a among the first sensor pads 421 may be electrically connected to the active area 411 (e.g., one of the photoelectric conversion elements) via electrical wires implemented inside the sensor member 453b. In an embodiment, the enlarged pads 421b among the first sensor pads 421 may be electrically connected to one of the substrate pads 425 by wire bonding and may also be electrically connected to one of the dummy pads 423 by wire bonding. The dummy pads 423 may be electrically connected to one of the photoelectric conversion elements via electrical wires implemented inside the sensor member 453b. For example, between the enlarged pads 421b among the first sensor pads 421 and the photoelectric conversion element(s), the dummy pad(s) 423 and/or the dummy wire(s) 429 may provide electrical wires. Accordingly, in electrically connecting the sensor pads (e.g., the first sensor pads 421) to the active area 411, some of the electrical wires may be implemented via wire bonding, thereby simplifying the arrangement and structure of electrical wires inside the sensor member 453b. In addition, by increasing the cross-sectional area of the electrical wires inside the sensor member 453b, line resistance may be suppressed, and power efficiency may be improved.

According to an embodiment, dummy wires 429 connected to the enlarged pads 421b among the first sensor pads 421 may extend across one or more dummy pads 423 (hereinafter, "support pads") to be electrically connected to the other dummy pads 423. In a structure where the dummy wires 429 are disposed to extend across the support pads, some of the dummy wires 429 may be fixed to the support pads. For example, even if the distance between two corresponding pads is long when electrically connecting the two pads, the dummy wires 429 may be stably disposed on the sensor member 453b by being partially fixed at predetermined positions on the sensor member 453b. In an embodiment, the surface of the support pads may be at least partially insulated, and some of the dummy wires 429 may be fixed to the support pad at an insulated area. In an embodiment, the dummy wires 429 may supply power and may be electrically connected to the active area 411 via the support pads. For example, when the support pads are not insulated, a single dummy wire 429 may extend from a sensor pad (e.g., a first sensor pad 421) and be electrically connected to multiple dummy pads 423, including the support pads, to supply or transmit power to the active area 411 (e.g., at least one of the photoelectric conversion elements).

Referring to FIG. 10, the dummy pads 523 (e.g., the dummy pads 423 of FIG. 8) may include a normal pad(s) 523a, a first enlarged pad(s) 523b, and/or a second enlarged pad(s) 523c. For example, the sensor member 453b may include dummy pads having a first size (e.g., normal pads 523a), dummy pads having a second size larger than the first size (e.g., first enlarged pads 523b), and dummy pads having a third size larger than the second size (e.g., second enlarged pads 523c). Here, the "size" of the dummy pads 523 may refer to the width or length of the dummy pads 523 as illustrated in FIG. 10. The dummy pads 523 are generally disposed in a direction different from the substrate pads 425 (e.g., at the third side SE3 of FIG. 8), while some dummy pads (e.g., first enlarged pads 523b) may be disposed in a direction adjacent to the substrate pads 425 (e.g., at the second side SE2 of FIG. 8). For example, some of the sensor pads (e.g., second sensor pads 522) may be disposed on the sensor member 453b in a direction different from the substrate pads 425 (e.g., at the third side SE3 of FIG. 8). In a structure where the second sensor pad(s) 522 is disposed at the third side SE3, the dummy pad(s) (e.g., first enlarged pad(s) 523b) disposed at the second side SE2 may function as a pad(s) for wire bonding, thereby electrically connecting the second sensor pad(s) 522 to the substrate pad(s) 425. In an embodiment, the second sensor pads 522 may be electrically connected to the substrate pads 425 via the first enlarged pads 523b and may be electrically connected to the active area 411 (e.g., one of the photoelectric conversion elements) via electrical wires inside the sensor member 453b.

According to an embodiment, the first enlarged pad(s) 523b among the dummy pads 523 may be disposed adjacent to the substrate pad(s) 425. For example, in a structure where the second sensor pad(s) 522 and the substrate pad(s) 425 are positioned too far apart for direct wire bonding, the first enlarged pad(s) 523b may be provided between the second sensor pad(s) 522 and the substrate pad(s) 425. In an embodiment, the first enlarged pad(s) 523b may be electrically connected to one of the substrate pad(s) 425 by wire bonding and may be further electrically connected to one of the second sensor pad(s) 522 by additional wire bonding and/or through any one of the dummy wire(s) 429. By having a larger size than the normal pad(s) 523a among the dummy pads 523, a first enlarged pad 523b may allow two wire bonds to be easily disposed on a single first enlarged pad 523b.

According to an embodiment, the second enlarged pads 523c among the dummy pads 523 may be larger than the normal pads 523a or the first enlarged pads 523b. For example, the second enlarged pads 523c may have a size corresponding to an area in which multiple normal pads 523a can be arranged linearly. In an embodiment, by disposing sufficiently large dummy pad(s) (e.g., the second enlarged pad(s) 523c) at arbitrary positions in an inactive area on the sensor member 453b, the arrangement of the dummy wires 429 may be implemented in various ways. In an embodiment, the second enlarged pads 523c may extend in one direction (e.g., the first direction D1 of FIG. 8) and may be arranged along a direction crossing the first direction D1 (e.g., the second direction D2 of FIG. 8).

According to an embodiment, when dummy wires 429 are connected to one of the second enlarged pads 523c, the dummy wires 429 may be disposed to extend across adjacent second enlarged pad(s) 523c. In an embodiment, at least a portion of the surface of the dummy pads (e.g., the second enlarged pads 523c) may be insulated. For example, in the second enlarged pads 523c of FIG. 10, the areas illustrated with shading may be understood as insulated areas formed by printing, painting, spraying, coating, and/or depositing an insulating material. Although not illustrated, in addition to the dummy pad(s) functioning as support pads, at least a portion of the surface of other dummy pads 523, the first sensor pads 421, and/or the second sensor pads 422 or 522 may be insulated.

According to an embodiment, the dummy wires 429 may be partially disposed corresponding to an insulated area, so that while being disposed to extend across the second enlarged pad(s) 523c, the dummy wires may not be electrically connected to the second enlarged pad(s) 523c. In an embodiment, some of the surfaces of the second enlarged pad(s) 523c may remain uninsulated and may be electrically connected to the dummy wires 429. For example, an insulated area may be formed on the surface of the second enlarged pad(s) 523c, while the surface of the second enlarged pad(s) 523c at the position where the dummy wire 429 is connected may be partially exposed. In an embodiment, when another pad(s) is disposed between two pads connected via a dummy wire 429, the dummy wire 429 may be fixed to the insulated area of the other pad(s).

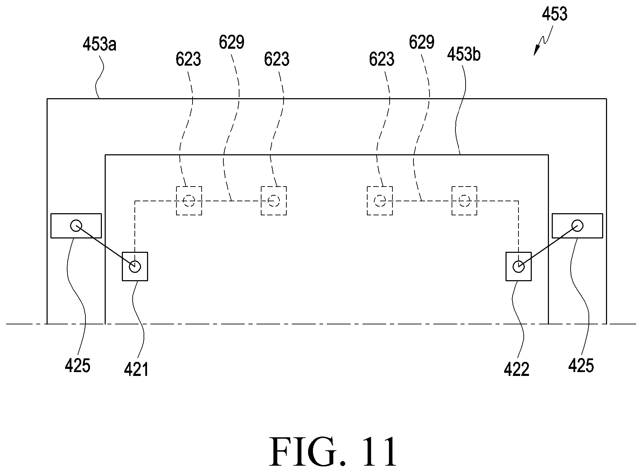

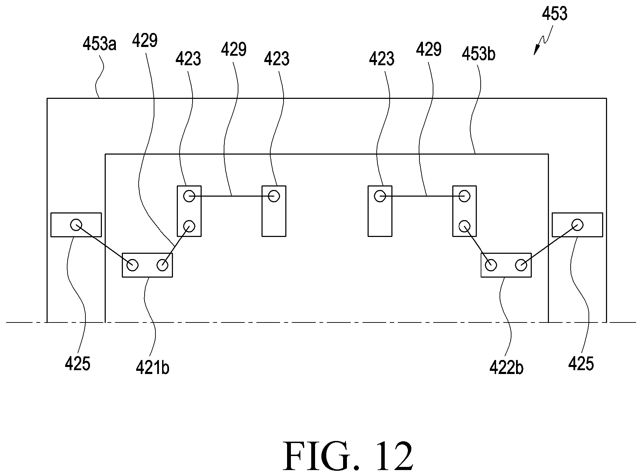

FIGS. 11 and 12 are views each illustrating an electrical connection structure of an image sensor 453 (e.g., the image sensor 353 or 453 of FIG. 7 or FIG. 8) according to an embodiment of the disclosure.

For example, FIG. 11 illustrates electrical wires implemented inside the sensor member 453b, and FIG. 12 illustrates a configuration in which the dummy pad(s) 423 functions as electrical wires by wire bonding outside the sensor member 453b. Referring to FIG. 11, the sensor pads 421 and 422 may be electrically connected to one of the substrate pads 425 by wire bonding. Inside the sensor member 453b, signal pads 623 electrically connected to the active area (e.g., the active area 411 of FIGS. 8 to 10) (e.g., photoelectric conversion element(s)) may be provided, and the signal pads 623 may be electrically connected to one of the sensor pads 421 or 422 via electrical wires 629 inside the sensor member 453b. In an embodiment, the sensor pad(s) 421 or 422 connected to the internal electrical wires of the sensor member 453b may be implemented as normal pads. Referring to FIG. 12, the sensor pads 421b and 422b implemented as enlarged pads may be electrically connected to one of the substrate pads 425 by wire bonding and may also be electrically connected to at least one of the dummy pads 423 by wire bonding. For example, the enlarged pad(s) (e.g., the sensor pad(s) indicated as "421b" and/or "422b") and the dummy pad(s) 423 may be electrically connected via the dummy wires 429. In an embodiment, at least one of the dummy pads 423 may be electrically connected to the active area (e.g., photoelectric conversion element(s)) via electrical wires provided inside the sensor member 453b (e.g., the electrical wires 629 of FIG. 11).

According to an embodiment, the electrical wires extending from the substrate pad(s) 425 and/or the sensor pad(s) 421 or 422 to the active area may be disposed inside the sensor member. When the image sensor 453 and/or the sensor member 453b is configured with higher pixel density or higher performance, the number of internal electrical wires may increase. For example, as the internal space of the sensor member 453b is limited, the cross-sectional area of the electrical wires may decrease and the line resistance may increase as more electrical wires are disposed. The image sensor 453 according to embodiments of the disclosure may suppress an increase in line resistance by including electrical wires implemented outside the sensor member 453b using the dummy pad(s) 423 and wire bonding structures. For example, in supplying power in the image sensor 453 according to an embodiment of the disclosure, power efficiency may be improved.

As described above, the image sensor (e.g., the image sensor 353 or 453 of FIGS. 6 to 12) and/or an electronic device (e.g., the electronic device 1001, 1002, 1004, 100, or 200 of FIGS. 1 to 5) including the image sensor, according to embodiments of the disclosure, may be improved in power efficiency and/or stability in power or electrical signal transmission by including electrical wires implemented using dummy pad(s) (e.g., the dummy pad(s) 423 or 523 of FIGS. 8 to 12) disposed at the periphery of the active area (e.g., the active area 411 of FIGS. 8 to 10) of a sensor member (e.g., the sensor member 353b or 453b of FIGS. 6 to 12). In an embodiment, when electrically connecting the sensor member to a substrate (e.g., the substrate 353a or 453a of FIGS. 6 to 12), substrate pads (e.g., the substrate pads 425 of FIGS. 8 to 12) for wire bonding may be disposed on both sides of the sensor member, allowing miniaturization in directions where the substrate pads are not disposed. When the image sensor is disposed such that the direction or area where the substrate pads are not disposed is adjacent to an edge of the electronic device, interference with other electronic components (e.g., the display 101 or 230) may be suppressed, and a favorable operating environment may be established. For example, even if an image sensor and/or a sensor member becomes larger and offers high performance, the image sensor and/or the sensor member may be easily disposed in a confined space.

The effects capable of being obtained by the disclosure are not limited to those described above, and other effects not described above may be clearly understood by a person ordinarily skilled in the art to which the disclosure belongs from the descriptions of the above-described embodiments.

According to an embodiment of the disclosure, an image sensor (e.g., the image sensor 353 or 453 of FIGS. 6 to 12) may include a substrate (e.g., the substrate 353a or 453a of in FIGS. 6 to 12) and a sensor member (e.g., the sensor member 353b or 453b of FIGS. 6 to 10) disposed on one surface of the substrate. The sensor member may include an active area (e.g., the active area 411 of FIGS. 8 to 10) constituted by an array of photoelectric conversion elements, first sensor pads (e.g., the first sensor pads 421 of FIGS. 8 to 12) arranged in a first direction (e.g., the first direction D1 of FIG. 8) at a first side (e.g., the first side SE1 of FIG. 8) of the periphery of the active area, second sensor pads (e.g., the second sensor pads 422 of FIGS. 8 to 12) arranged in the first direction at a second side (e.g., the second side SE2 of FIG. 8) of the periphery of the active area opposite to the first side, and at least one dummy pad (e.g., the dummy pad 423 or 523 of FIGS. 7 to 12) disposed at the periphery of the active area. For example, the first sensor pads and the second sensor pads may be electrically connected to the substrate by wire bonding. In an embodiment, the at least one dummy pad may be disposed at a third side (e.g., the third side SE3 in FIG. 8) of the periphery of the active area, which connects one end portion of the first side and one end portion of the second side, and may be electrically connected to one of the first sensor pads or one of the second sensor pads by wire bonding.

According to an embodiment, at the third side (e.g., the third side SE3 of FIG. 8) of the periphery of the active area, which connects one end portion of the first side and one end portion of the second side, multiple dummy pads may be arranged in a second direction (e.g., the second direction D2 of FIG. 8) crossing the first direction.

According to an embodiment, the second direction may be perpendicular to the first direction.

According to an embodiment, the at least one dummy pad may be configured to receive power or transmit an electrical signal via one of the first sensor pads or one of the second sensor pads.

According to an embodiment, one of the photoelectric conversion elements may be electrically connected to one of the first sensor pads or one of the second sensor pads via the at least one dummy pad.

According to an embodiment, multiple dummy pads may be disposed, and one of the first sensor pads or one of the second sensor pads may be electrically connected to at least two of the multiple dummy pads.

According to an embodiment, a sensor pad electrically connected to the at least one dummy pad among the first sensor pads and the second sensor pads may have a greater length or a greater width than a sensor pad not electrically connected to the at least one dummy pad.

According to an embodiment, the image sensor as described above may further include substrate pads (e.g., the substrate pads 425 of FIGS. 8 to 12) disposed at one side or the other side of the sensor member on one surface of the substrate and arranged in the first direction. In an embodiment, the substrate pads may be electrically connected to one of the first sensor pads or one of the second sensor pads by wire bonding.

According to an embodiment, a surface of the at least one dummy pad, a surface of the first sensor pads, or a surface of the second sensor pads may be at least partially insulated (see, e.g., the second extended pad 523c of FIG. 10).

According to an embodiment, the image sensor as described above may further include a dummy wire (e.g., the dummy wire 429 of FIG. 9 or FIG. 10) electrically connecting two corresponding pads among the at least one dummy pad, the first sensor pads, or the second sensor pads.

According to an embodiment, the dummy wire may be disposed across an insulated area of one of the at least one dummy pad, the first sensor pads, or the second sensor pads between the two corresponding pads.

According to an embodiment, a portion of the dummy wire may be fixed to the insulated area of one of the at least one dummy pad, the first sensor pads, or the second sensor pads.

According to an embodiment of the disclosure, an electronic device (e.g., the electronic device 1001, 1002, 1004, 100, or 200 of FIGS. 1 to 5) may include a housing (e.g., the housing 110 or 201 of FIGS. 2 to 5) including a front surface (e.g., the first surface 110A of FIG. 2), a rear surface (e.g., the second surface 110B of FIG. 3) facing away from the front surface, and a side surface structure (e.g., the side surface structure 210 of FIG. 4 or FIG. 5) surrounding a space between the front surface and the rear surface, an image sensor (e.g., the image sensor 353 or 453 of FIGS. 6 to 12) disposed inside the housing and configured to receive incident light transmitted through one of the front surface, the rear surface, and the side surface structure, and a processor (e.g., the processor 1020 of FIG. 1) configured to obtain an image of a subject based on the light received through the image sensor. In an embodiment, the image sensor may include a substrate (e.g., the substrate 353a or 453a FIGS. 6 to 12) and a sensor member (e.g., the sensor member 353b or 453b of FIGS. 6 to 10) disposed on one surface of the substrate. The sensor member may include an active area (e.g., the active area 411 of FIGS. 8 to 10) constituted by an array of photoelectric conversion elements, first sensor pads (e.g., the first sensor pads 421 of FIGS. 8 to 12) arranged in a first direction (e.g., the first direction D1 of FIG. 8) at a first side (e.g., the first side SE1 of FIG. 8) of the periphery of the active area, second sensor pads (e.g., the second sensor pads 422 of FIGS. 8 to 12) arranged in the first direction at a second side (e.g., the second side SE2 of FIG. 8) of the periphery of the active area opposite to the first side, and at least one dummy pad (e.g., the dummy pad 423 or 523 of FIGS. 7 to 12) disposed at the periphery of the active area. In an embodiment, the first sensor pads and the second sensor pads may be electrically connected to the substrate by wire bonding, and the at least one dummy pad may be disposed at a third side (e.g., the third side SE3 of FIG. 8) of the periphery of the active area, which connects one end portion of the first side and one end portion of the second side, and may be electrically connected to one of the first sensor pads or one of the second sensor pads by wire bonding.

According to an embodiment, the third side may be disposed adjacent to another one of the front surface, the rear surface, and the side surface structure.

According to an embodiment, the third side (e.g., the third side SE3 of FIG. 8) of the periphery of the active area, which connects the one end portion of the first side and the one end portion of the second side, may be disposed adjacent to another one of the front surface, the rear surface, and the side surface structure. In an embodiment, at the third side, multiple dummy pads may be arranged in a second direction (e.g., the second direction D2 of FIG. 8) crossing the first direction.

According to an embodiment, the at least one dummy pad may be configured to receive power or transmit an electrical signal via one of the first sensor pads or one of the second sensor pads.

According to an embodiment, a sensor pad electrically connected to the at least one dummy pad among the first sensor pads and the second sensor pads may have a greater length or a greater width than a sensor pad not electrically connected to the at least one dummy pad.

According to an embodiment, the image sensor may further include substrate pads (e.g., the substrate pads 425 of FIGS. 8 to 12) disposed at one side or the other side of the sensor member on one surface of the substrate and arranged in the first direction. For example, the substrate pads may be electrically connected to one of the first sensor pads or one of the second sensor pads by wire bonding.

According to an embodiment, a surface of the at least one dummy pad, a surface of the first sensor pads, or a surface of the second sensor pads may be at least partially insulated (see, e.g., the second extended pad 523c of FIG. 10).

According to an embodiment, the image sensor may further include a dummy wire (e.g., the dummy wire 429 e of FIG. 9 or FIG. 10) electrically connecting two corresponding pads among the at least one dummy pad, the first sensor pads, or the second sensor pads. In an embodiment, the dummy wire may be disposed across an insulated area of one of the at least one dummy pad, the first sensor pads, or the second sensor pads between the two corresponding pads.

Although the disclosure has been described with reference to an embodiment as an example, it is to be understood that the embodiment is intended to be exemplary and is not limiting the disclosure. It will be apparent to those skilled in the art that various changes in form and detail may be made without departing from the overall scope of the disclosure, including the appended claims and their equivalents. For example, the above-described embodiments are illustrated as having a sensor member 353b or 453b that includes photoelectric conversion elements. However, another semiconductor device that is electrically connected to the substrate (e.g., the substrate 353a or 453a) by including electrode pads (e.g., the sensor pads 421 and 422 or the dummy pads 423) may replace the above-described sensor member 353b or 453b.

## Claims

1. An image sensor (353; 453) comprising:
a substrate (353a; 453a); and
a sensor member (353b; 453b) disposed on one surface of the substrate, wherein the sensor member comprises an active area (411) constituted by an array of photoelectric conversion elements, first sensor pads (421) arranged in a first direction (D1) at a first side (SE1) of a periphery of the active area, second sensor pads (422) arranged in the first direction at a second side (SE2) of the periphery of the active area opposite to the first side, and at least one dummy pad (423, 523) disposed at the periphery of the active area,
wherein the first sensor pads and the second sensor pads are electrically connected to the substrate by wire bonding, and
wherein the at least one dummy pad is disposed at a third side (SE3) of the periphery of the active area, which connects one end portion of the first side and one end portion of the second side, and is electrically connected to one of the first sensor pads or one of the second sensor pads by wire bonding.

2. The image sensor according to claim 1, wherein at the third side, multiple dummy pads are arranged in a second direction crossing the first direction.

3. The image sensor according to claim 2, wherein the second direction is perpendicular to the first direction.

4. The image sensor according to any one of claims 1 to 3, wherein the at least one dummy pad is configured to receive power or transmit an electrical signal via one of the first sensor pads or one of the second sensor pads.

5. The image sensor according to any one of claims 1 to 4, wherein one of the photoelectric conversion elements is electrically connected to one of the first sensor pads or one of the second sensor pads via the at least one dummy pad.

6. The image sensor according to any one of claims 1 to 5, wherein multiple dummy pads are disposed, and one of the first sensor pads or one of the second sensor pads is electrically connected to at least two of the multiple dummy pads.

7. The image sensor according to any one of claims 1 to 6, wherein a sensor pad electrically connected to the at least one dummy pad among the first sensor pads and the second sensor pads has a greater length or a greater width than a sensor pad not electrically connected to the at least one dummy pad.

8. The image sensor according to any one of claims 1 to 7, further comprising:
substrate pads (425) disposed at one side or another side of the sensor member on one surface of the substrate and arranged in the first direction,
wherein the substrate pads are electrically connected to one of the first sensor pads or one of the second sensor pads by wire bonding.

9. The image sensor according to any one of claims 1 to 8, wherein a surface of the at least one dummy pad, a surface of the first sensor pads, or a surface of the second sensor pads is at least partially insulated.

10. The image sensor according to claim 9, further comprising:
a dummy wire (429) electrically connecting two corresponding pads among the at least one dummy pad, the first sensor pads, or the second sensor pads.

11. The image sensor according to claim 10, wherein the dummy wire is disposed across an insulated area of one of the at least one dummy pad, the first sensor pads, or the second sensor pads between the two corresponding pads.

12. The image sensor according to claim 11, wherein a portion of the dummy wire is fixed to an insulated area of one of the at least one dummy pad, the first sensor pads, or the second sensor pads.

13. An electronic device (1001; 1002; 1004; 100; 200) comprising:
a housing (110; 201) comprising a front surface (110A), a rear surface (110B) facing away from the front surface, and a side surface structure (210) surrounding a space between the front surface and the rear surface;
an image sensor (353; 453) disposed inside the housing and configured to receive incident light transmitted through one of the front surface, the rear surface, and the side surface structure, the image sensor being the image sensor according to any one of claims 1 to 12; and
a processor (1020) configured to acquire an image of a subject based on the light received through the image sensor.

14. The electronic device of claim 13, wherein the third side is disposed adjacent to another one of the front surface, the rear surface, and the side surface structure.

15. The electronic device of claim 13, wherein the third side (SE3) of the periphery of the active area, which connects the one end portion of the first side and one the end portion of the second side, is disposed adjacent to the another one of the front surface, the rear surface, and the side surface structure, and
wherein, at the third side, multiple dummy pads are arranged in a second direction (D2) crossing the first direction.
